# EUROPEAN PATENT APPLICATION

(11) **EP 2 639 278 A1**
(43) Date of publication of application: **18.09.2013**
(21) Application number: 12159244.8
(22) Date of filing: 13.03.2012
(51) Int. Cl.: C09J 7/02, H01L 21/56

(54) **Heat-resistant pressure-sensitive adhesive tape for production of semiconductor device and method for producing seminconductor device using the tape**

(71) Applicant: Nitto Denko Corporation, Ibaraki-shi, Osaka (JP)
(72) Inventor: Arimitsu, Yukio, Ibaraki-shi (JP)
(74) Representative: Grünecker, Kinkeldey, Stockmair & Schwanhäusser

(57) **Abstract**

The present invention provides a heat-resistant pressure-sensitive adhesive tape for the production of a semiconductor device, which includes a base material layer having a glass transition temperature exceeding 180°C, and a pressure-sensitive adhesive layer having an elastic modulus at 180°C of 1.0× 10⁵ Pa or more, which is formed on one side or both sides of the base material layer.

In preferred embodiments the base material is polyimide and the adhesive layer is selected from silicone-based pressure-sensitive adhesives and acrylic pressure-sensitive adhesives.

The heat-resistant pressure-sensitive adhesive tape of the present invention can be used for temporarily fixing a chip in a production method of a substrateless semiconductor package which does not use a metal frame (for example, a production method of WLP).

## Description

### FIELD OF THE INVENTION

The present invention relates to a heat-resistant pressure-sensitive adhesive tape for the production of a semiconductor device, which is used for temporarily fixing a chip in a method for producing a substrateless semiconductor package which does not use a metal lead frame; and a method for producing a semiconductor device using the tape.

### BACKGROUND OF THE INVENTION

In recent years, CSP (Chip Size/Scale Package) technique is noted in a mounting technology of LSI, Of the technology, a package in a form where a substrate is not used and only a chip is used, that is represented by WLP (Wafer Level Package), is one of package forms particularly noted in terms of size reduction and high integration. According to a production method of WLP, plural semiconductor Si wafer chips arranged in an orderly manner without using a substrate are en bloc encapsulated with an encapsulation resin, and then divided into individual structures by cutting, whereby a smaller-sized package than the conventional package using a substrate can be efficiently produced.

Such a production method of WLP is required to fix a chip conventionally fixed to a substrate on a separate support. Furthermore, the fixation must be released after molding into an individual package through resin encapsulation. Therefore, the support should not be permanently adhered, but must be repeelable, From this point, there is a technique of using a pressure-sensitive adhesive tape as a support for temporarily fixing the chip.

Patent Document 1: JP-A-2001-308116
Patent Document 2: JP-A-2001-313350

### SUMMARY OF THE INVENTION

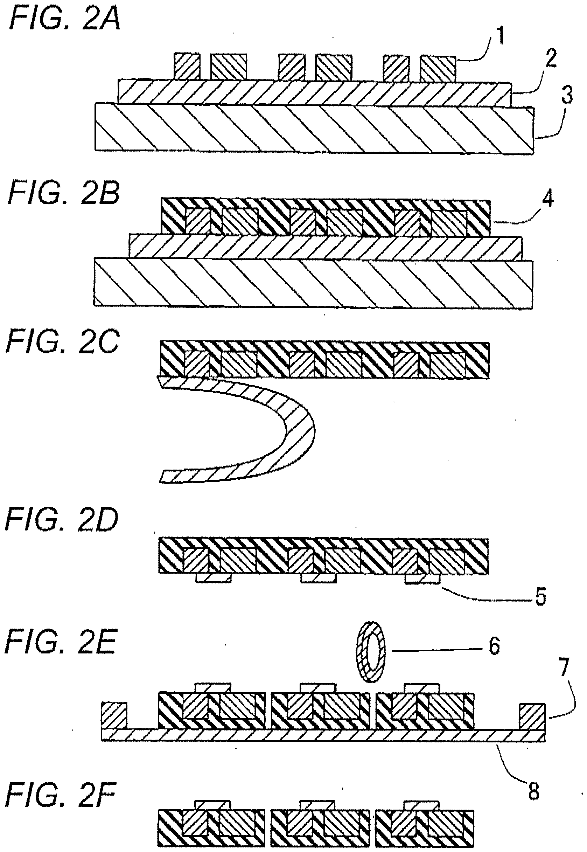

Problems to be solved by the present invention are described below with reference to Figs. 2A to 2F showing a method for producing a substrateless semiconductor device.
Plural chips 1 are adhered to a heat-resistant pressure-sensitive adhesive tape 2 for the production of a semiconductor device, which has pressure-sensitive adhesive layers on both sides thereof, and the heat-resistant pressure-sensitive adhesive tape 2 for the production of a semiconductor device is fixed to a substrate 3 to form a structure as shown in Fig. 2A. Alternatively, the heat-resistant pressure-sensitive adhesive tape 2 for the production of a semiconductor device is adhered to the substrate 3, and the chips 1 are then fixed to the tape 2 to form a structure shown in Fig. 2A.

The chips 1 having the structure shown in Fig. 2A are encapsulated with an encapsulation resin 4 from the upper of the chips 1 so as to integrate plural chips 1 to form a structure shown in Fig. 2B.
Then, as shown in Fig. 2C, plural chips 1 encapsulated with the encapsulation resin 4 is obtained by a method of separating the plural chips 1 encapsulated with the encapsulation resin 4 from the integrated product of the heat-resistant pressure-sensitive adhesive tape 2 for the production of a semiconductor device and the substrate 3, or a method of peeling an assembly including the plural chips 1 encapsulated with the encapsulation resin 4 and the heat-resistant pressure-sensitive adhesive tape 2 for the production of a semiconductor device from the substrate and then peeling only the heat-resistant pressure-sensitive adhesive tape 2 for the production of a semiconductor device from the encapsulated chips.

An electrode 5 is formed on a necessary area on the surface of the chip 1 at a side of the plural chips 1 encapsulated with the encapsulation resin 4, on which the heat-resistant pressure-sensitive adhesive tape 2 for the production of a semiconductor device was provided and the surface of the chip 1 is exposed, thereby forming a structure shown in Fig. 2D.
Then, a dicing tape 8 optionally having a dicing ring 7 at an encapsulation resin side is adhered to the structure to fix plural chips 1 encapsulated with the encapsulation resin 4 for the purpose of a dicing step. The resulting assembly is subjected to dicing with a dicing blade 6 as shown in Fig. 2E, thereby finally obtaining plural substrateless packages each having plural chips encapsulated with the resin, as shown in Fig. 2F.

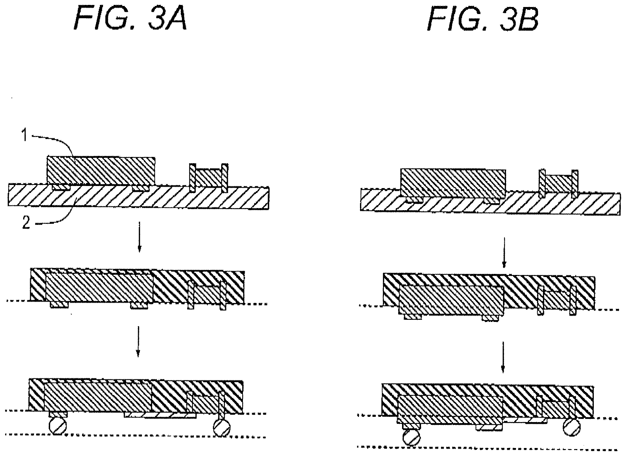

In such a method, there are cases where the chip is not held by the tape due to the pressure of the encapsulation resin and deviates from a designated position, or the chip 1 may be embedded in the heat-resistant pressure-sensitive adhesive tape 2 for the production of a semiconductor device for the reason that pressure of the encapsulation resin is too strong, or the heat-resistant pressure-sensitive adhesive tape 2 for the production of a semiconductor device is too soft, or for those combined reasons as shown in Fig. 3B. In such a case, there is a concern that the chip 1 cannot completely be encapsulated with the encapsulation resin 4, and the chip protrudes from the surface of the resin to form a state (standoff) that difference in level is generated between an encapsulation resin face and a chip face.
In the case of the state that a part of the chips 1 protrudes from the resin face, deviation occurs in height of a face of an electrode formed later. Therefore, in connecting the chip to a circuit substrate, it becomes difficult to surely connect the chip to the circuit substrate.

In the case that the chip 1 is not embedded in the heat-resistant pressure-sensitive adhesive tape 2 for the production of a semiconductor device, the chip does not protrude from the face of the cured encapsulation resin as shown in Fig. 3A, and subsequent formation of an electrode between the chips is surely conducted. Furthermore, even in the case of providing the package on the circuit substrate, each electrode can surely be connected to a predetermined area on the circuit substrate.

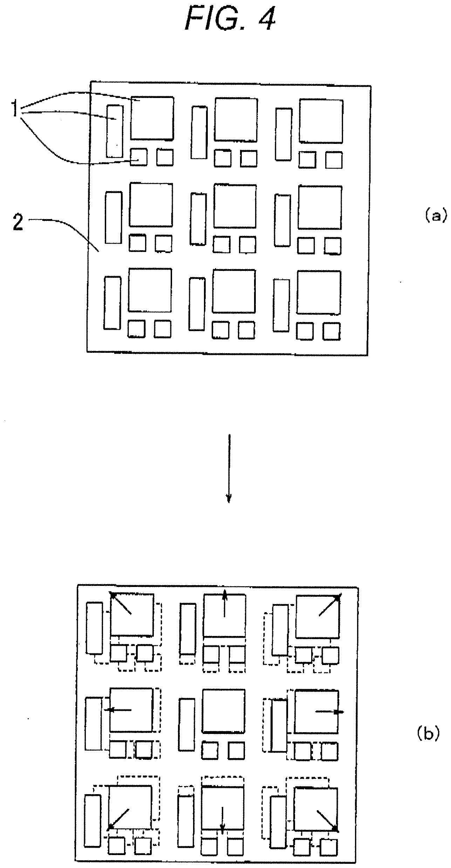

In addition, during encapsulation with a resin, the heat-resistant pressure-sensitive adhesive tape 2 for the production of a semiconductor device shown in (a) of Fig. 4 deforms in a planar direction as shown in (b) Fig. 4 due to expansion and elasticity of a base material layer and a pressure-sensitive adhesive layer of the heat-resistant pressure-sensitive adhesive tape 2 for the production of a semiconductor device, whereby the position of the chip 1 provided on the heat-resistant pressure-sensitive adhesive tape 2 for the production of a semiconductor device may move in some cases. Furthermore, the chip may sometimes move due to the pressure caused at the time of packing a resin used for encapsulation.
As a result, in providing an electrode on the chip 1, relative positional relationship between the chip and the electrode differs from the predetermined positional relationship. Furthermore, in encapsulating the chip 1 with a resin and subsequent dicing, a dicing line in a dicing step that has been previously determined based on the predetermined position of the chip 1 differs from a dicing line that becomes necessary by the actual position of the chip 1.
In such a case, each package obtained by dicing generates deviation at the position of the chip encapsulated, and the subsequent step cannot advance smoothly. Furthermore, a package which is not sufficiently encapsulated may undesirably be obtained.

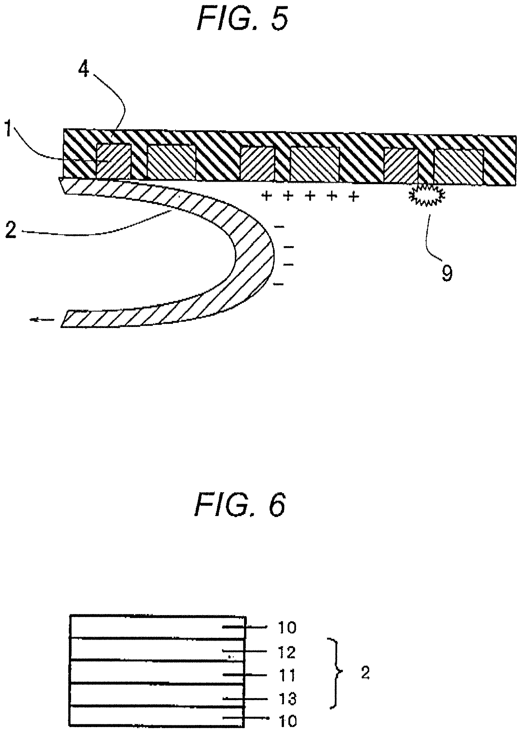

In peeling the heat-resistant pressure-sensitive adhesive tape 2 for the production of a semiconductor device from the chip encapsulated with a resin, particularly depending on the properties of a pressure-sensitive adhesive formed at the chip side of the heat-resistant pressure-sensitive adhesive tape 2 for the production of a semiconductor device, adhesive force becomes strong due to curing of an encapsulation resin and heat, thereby showing heavy peelability. Therefore, there is a concern that peeling becomes difficult, adhesive residue as shown in Fig. 5 occurs, or peel charging occurs.
Where peeling becomes difficult, time for peeling is prolonged, resulting in deterioration of productivity. Where an adhesive residue 9 as shown in Fig. 5 occurs, the subsequent step such as formation of an electrode cannot be carried out. Furthermore, where peel discharging is generated, disadvantage may occur in the subsequent step due to adhesion of dusts and the like.

As mentioned above, in the method for producing a substrateless semiconductor package using a heat-resistant pressure-sensitive adhesive tape for the production of a semiconductor device as a support for temporary fixation, the chip is not held by the tape due to the pressure when encapsulating with a resin, and deviates from the designated position. In addition, the chip embeds in a pressure-sensitive adhesive layer due to the pressure when adhering the chip or when encapsulating with a resin, and difference in level (standoff) in which the chip face becomes protruded with respect to the encapsulation resin face occurs. Furthermore, the pressure-sensitive adhesive tape may become strongly adhered to the chip surface due to curing of an encapsulation resin and heat and the package may break in peeling the tape.

The present invention provides a heat-resistant pressure-sensitive adhesive tape for the production of a semiconductor device, which is to be used by being adhered to a substrateless semiconductor chip which does not use a metal lead frame in encapsulating the chip with a resin, the tape comprising a base material layer having a glass transition temperature exceeding 180°C, and a pressure-sensitive adhesive layer having an elastic modulus at 180°C of 1.0×10⁵ Pa or more, which is formed on one side or both sides of the base material layer.
In one preferred embodiment, the base material layer has a coefficient of linear expansion in a temperature range of from 0 to 180°C of 3.0×10⁻⁵/°C or less.
In another preferred embodiment, the heat-resistant pressure-sensitive adhesive tape has a 180° peel adhesive force at at least one point in a temperature range of from 0 to 180°C to a silicon wafer of 50 mN/20 mm or more.
In still another preferred embodiment, the heat-resistant pressure-sensitive adhesive tape has a 180° peel adhesive force at at least one point in a temperature range of from 0 to 180°C to an encapsulation resin cured on the pressure-sensitive adhesive layer of 20 N/20 mm or less.
In still another preferred embodiment, the pressure-sensitive adhesive layer has a weight loss at 180°C of 3.0% by weight or less.
In addition, the present invention also provides a method for producing a semiconductor device in which a substrateless semiconductor chip which does not use a metal lead frame is encapsulated with a resin, the method comprising using the above-mentioned heat-resistant pressure-sensitive adhesive tape for the production of a semiconductor device.

The present invention can provide a heat-resistant pressure-sensitive adhesive tape for the production of a semiconductor device, which is a pressure-sensitive adhesive tape used for temporarily fixing a chip in a production method of a substrateless semiconductor package which does not use a metal frame (for example, a production method of WLP), wherein the tape holds the chip such that the chips does not transfer during a resin encapsulation step, thereby reducing deviation of the position of the chip from the designated position, standoff by embedding the chip in a pressure-sensitive adhesive layer is small, and the tape can be light-peeled after the use.

### BRIEF DESCRIPTION OF THE DRAWINGS

Fig. 1 is a flow chart showing steps of producing a substrateless BGA using the heat-resistant pressure-sensitive adhesive tape for the production of a semiconductor device of the present invention.
Figs. 2A to 2F are schematic views showing a production method of a substrateless package.
Figs. 3A and 3B are views comparing the case that a chip does not involve standoff and the case that a chip involves standoff.
Fig. 4 is a view showing that a heat-resistant pressure-sensitive adhesive tape for the production of a semiconductor device, having a chip mounted thereon deforms by heat when encapsulating with an encapsulation resin.
Fig. 5 is a view showing occurrence of charging and adhesive residue in peeling the heat-resistant pressure-sensitive adhesive tape for the production of a semiconductor device.
Fig. 6 is a cross-sectional view of the heat-resistant pressure-sensitive adhesive tape for the production of a semiconductor device of the present invention.

### Description of Reference Numerals and Signs

1: Chip
2: Heat-resistant pressure-sensitive adhesive tape for production of semiconductor device
3: Substrate
4: Encapsulation resin
5: Electrode
6: Dicing blade
7: Dicing ring
8: Dicing tape
9: Adhesive residue
10: Smooth release sheet
11: Base material layer
12: Pressure-sensitive adhesive layer
13: Pressure-sensitive adhesive layer for substrate fixation
14: Terminal

### DETAILED DESCRIPTION OF THE INVENTION

As a result of various investigations to overcome the above problems, the present inventors have found as follows. In encapsulating a chip, heating is conducted to cure an encapsulation resin (generally from 150 to 180°C). In this case, when a base material having a glass transition temperature higher than the heating temperature is used as a base material of a pressure-sensitive adhesive tape for fixing the chip, a coefficient of linear expansion of the pressure-sensitive adhesive tape is small even in a temperature region higher than the heating temperature. As a result, the chip adhered does not deviate from the designated position, and positional accuracy can be prevented from being deteriorated.

As represented by a monoaxially or biaxially stretched base material, elongation caused by stretching or the like in a production step of a tape begins to shrink at a temperature higher than the glass transition temperature, and the shrinkage occurred at a temperature higher than the glass transition point has different degree of shrinkage in an MD direction and a TD direction in many cases. However, when the glass transition temperature of the tape is higher than the heating temperature when encapsulating a chip with a resin, the tape does not shrink. Therefore, the chip adhered does not deviate from the designated position, and positional accuracy will not be deteriorated.

Therefore, when a base material layer having a glass transition temperature higher than 180°C is used as the base material layer for use in a heat-resistant pressure-sensitive adhesive tape for the production of a semiconductor device, which is to be used by being adhered to a substrateless semiconductor chip which does not use a metal lead frame in encapsulating the chip with a resin, the positional accuracy of the chip can be improved. Furthermore, when a coefficient of linear expansion in a temperature range of from 0 to 180°C of the base material layer is 3.0×10⁻⁵/°C or less, deviation of the adhered chip from the designated position due to expansion of the base material layer can further be decreased.

When the elastic modulus at 180°C of the pressure-sensitive adhesive layer is 1.0×10⁵ Pa or more, it is possible to decrease embedding of the chip into the pressure-sensitive adhesive layer due to pressure when adhering the chip to the tape and when encapsulating the chip with a resin, as well as difference in level (stand-off) that the chip face becomes protruded with respect to the encapsulation resin face, which is accompanied with the embedding. In addition, there is a need to adhere the chip to the pressure-sensitive adhesive tape to surely hold the chip. Therefore, 180° peel adhesive force of the pressure-sensitive adhesive tape at at least one point in a temperature range of from 0 to 180°C to a silicon wafer having the pressure-sensitive adhesive tape adhered thereto is preferably 50 mN/20 mm or more.

After encapsulation, the pressure-sensitive tape may strongly adhered to the chip face due to curing of the encapsulation resin and heat, which may cause breakage of the package in peeling the pressure-sensitive adhesive tape. Particularly, because the resin is cured on the pressure-sensitive adhesive layer, adhesiveness to the resin tends to be increased. Therefore, when 180° peel adhesive force of the pressure-sensitive adhesive tape at at least one point in a temperature range of from 0 to 180°C to an encapsulation resin cured on the pressure-sensitive adhesive layer is 20 N/20 mm or less, the pressure-sensitive adhesive tape can be peeled without breakage of the package.

In the step of heat curing the encapsulation resin, there is a case where the package has been contaminated with a gas generated from the pressure-sensitive tape, resulting in deterioration of the reliability of package, such as poor plating during rewiring. When weight loss at 180°C of the pressure-sensitive adhesive layer is 3.0% by weight or less, the pressure-sensitive adhesive layer can be used in this application without deterioration of reliability of the package.

### Heat-resistant pressure-sensitive adhesive tape for production of semiconductor device

Embodiments of the heat-resistant pressure-sensitive adhesive tape 2 for the production of a semiconductor device of the present invention and the semiconductor device are specifically described below by reference to the accompanying drawings. Firstly, the heat-resistant pressure-sensitive adhesive tape 2 for the production of a semiconductor device of the present invention is described below. As shown in the cross-sectional view of Fig. 6, the heat-resistant pressure-sensitive adhesive tape 2 for the production of a semiconductor device of the present invention includes a base material layer 11 and a pressure-sensitive adhesive layer 12, The tape 2 may further include a pressure-sensitive adhesive layer for fixing the tape to a metal substrate or the like at a side opposite a face to which a chip is to be fixed and encapsulated, like a pressure-sensitive adhesive layer 13 for substrate fixation. Compositions of these pressure-sensitive adhesive layers used are not particularly limited. Any material may be used so long as it can surely fix a base material and the tape in each step of chip adhering, injection of an encapsulation resin, and curing of the encapsulation resin.
To protect the surfaces of the both pressure-sensitive adhesive layers in the heat-resistant pressure-sensitive adhesive tape 2 for the production of a semiconductor device before use, a release sheet 10 may be adhered to the surface of each pressure-sensitive adhesive layer.

### Base material layer

In the base material layer 11 used in the present invention, the kind of the base material layer is not particularly limited. However, in case where a base material having a glass transition temperature lower than a heating temperature for curing the encapsulation resin is used, a coefficient of linear expansion in a temperature region higher than the glass transition temperature is larger than that in a temperature region lower than the glass transition temperature, resulting in deterioration of accuracy from the designated position of the chip adhered.

In addition, in a monoaxially or biaxially stretched base material, elongation caused by stretching begins to shrink at a temperature higher than the glass transition temperature, and this leads to deterioration of accuracy from the designated position of the chip adhered. For this reason, in resin encapsulating a substrateless semiconductor chip which does not use a metal lead frame, when the glass transition temperature of the base material layer 11 used in the heat-resistant pressure-sensitive adhesive tape 2 for the production of a semiconductor device which is used by being adhered to the chip exceeds 180°C, positional accuracy of the chip can be improved. From this point, the base material is preferably a heat-resistant base material, and is preferably selected from plastic base materials such as polyester, polyamide, polyphenylene sulfide, polyether imide, polyimide, polyamideimide, polysulfone, and polyether ketone; porous base materials of the plastic base materials; paper base materials such as glassine paper, high quality paper and Japanese paper; non-woven fabric base materials such as cellulose, polyamide, polyester and aramide; metal film base materials such as aluminum foil, SUS foil and Ni foil. The "glass transition emperature" used herein means a temperature showing a peak of loss tangent (tan δ) confirmed under the conditions of temperature rising rate: 5°C/min, sample width: 5 mm, distance between chucks: 20 mm, and frequency; 10 Hz in a DMA method (tensile method).

When the coefficient of linear expansion in a temperature range of from 0 to 180°C of the base material is 3.0×10⁻⁵/°C or less, and preferably 2.0×10⁻⁵/°C or less, deviation of the chip adhered from the designated position due to expansion of the base material can further be reduced. For this reason, the base material is more preferably polyimide having heat resistance and a relatively small coefficient of linear expansion.
The base material has a thickness of generally from 5 to 200 µm, preferably from 10 to 150 µm, and more preferably from 20 to 100 µm. Where the thickness is less than 5 µm, in peeling the heat-resistant pressure-sensitive adhesive tape 2 for the production of a semiconductor device after curing the encapsulation resin, the heat-resistant pressure-sensitive adhesive tape 2 for the production of a semiconductor device breaks, and may not be peeled. The thickness exceeding 200 µm increases costs.

### Pressure-sensitive adhesive layer

In the pressure-sensitive adhesive layer 12 used in the present invention, the pressure-sensitive adhesive is not particularly limited so long as it has heat resistance.
Specifically, various kinds of pressure-sensitive adhesives such as acrylic pressure-sensitive adhesive, silicone-based pressure-sensitive adhesive, rubber-based pressure-sensitive adhesive and epoxy-based pressure-sensitive adhesive, that can adhere a chip to a sheet at ordinary temperatures, may be used. In addition, when adhering the chip to the sheet, adhesion may be conducted by heating, not at ordinary temperatures. From this point, various kinds of pressure-sensitive adhesives are used, and examples thereof include thermoplastic polyimide resins having heat resistance, polyether imide resins, polyether amide resins, polyamide imide resins, polyether amide imide resins, block copolymer such as styrene-ethylenebutylene-styrene (SEBS), styrene-butadiene-styrene (SBS), styrene-isobutadiene-styrene (SIS) and the like, and fluorine-containing resins.
Of those, from the standpoints of heat resistance and costs, silicone-based pressure-sensitive adhesives and acrylic pressure-sensitive adhesives are preferably used, and silicone-base pressure-sensitive adhesives are more preferably used.
Examples of the silicone-based pressure-sensitive adhesive include those containing dimethylpolysiloxane.

Examples of the acrylic pressure-sensitive adhesives include those including an acrylic copolymer obtained by copolymerization of monomers containing at least an alkyl (meth)acrylate. In the present specification, the term "alkyl (meth)acrylate" means alkyl acrylate and/or alkyl methacrylate.
Examples of the alkyl (meth)acrylate include methyl (meth)acrylate, ethyl (meth)acrylate, butyl (meth)acrylate, isoamyl (meth)acrylate, n-hexyl (meth)acrylate, 2-ethylhexyl (meth)acrylate, isooctyl (meth)acrylate, isononyl (meth)acrylate, decyl (meth)acrylate, and dodecyl (meth)acrylate. Of those, a copolymer of an acrylic acid monomer and a 2-ethylhexyl (meth)acrylate monomer, and a copolymer of methyl (meth)acrylate and/or ethyl (meth)acrylate, an acrylic acid monomer and a 2-ethylhexyl (meth)acrylate monomer are preferred.

As the silicone-based pressure-sensitive adhesive, there may be used an addition polymerization type silicone pressure-sensitive adhesive obtained by crosslinking an organopolysiloxane structure, preferably a dimethyl polysiloxane structure, using an unsaturated group such as vinyl group, and an SiH group, and then curing with a platinum catalyst, or a silicone pressure-sensitive adhesive obtained by curing with an organic peroxide such as BPO. Addition polymerization type one is preferred from the standpoint of heat resistance. In this case, crosslinking density can be adjusted according to the density of unsaturated group, considering adhesive force obtained.
Formation of a pressure-sensitive adhesive layer of this silicone pressure-sensitive adhesive requires conducting heating or the like in order to conduct addition polymerization.

If necessary, the pressure-sensitive adhesive layer may contain a cross-linking agent.
Examples of the cross-linking agent include an isocyanate cross-linking agent, an epoxy cross-linking agent, an aziridine compound and a chelate cross-linking agent.
The content of the cross-linking agent is not particularly limited. In the case of using the acrylic pressure-sensitive adhesive, the content of the cross-linking agent is preferably from 0.1 to 20 parts by weight, and more preferably from 0.5 to 10 parts by weight, per 100 parts by weight of the acrylic polymer.

When the pressure-sensitive adhesive layer 12 has an elastic modulus at 180°C of 1.0×10⁵ Pa or more, preferably 2.0×10⁵ Pa or more, and more preferably 3.0×10⁵ Pa or more, it becomes possible to decrease the difference in level (stand-off) where a chip face becomes protruded than the encapsulation resin, which is accompanied with the embedding of the chip in the pressure-sensitive adhesive layer 12 due to the pressure generated when adhering the chip to the tape or when encapsulating the chip with a resin. When the elastic modulus at 180°C is less than 1.0×10⁵ Pa, the pressure-sensitive adhesive layer 12 easily deforms due to pressure of resin encapsulation, and standoff is increased. When the standoff is increased, in the subsequent step of rewiring the package, the difference in level become larger than the thickness of the wiring, and conduction is not taken, resulting in poor package.

Furthermore, since the chip needs to be adhered to the sheet to surely hold the same, the 180° peel adhesive force of the heat-resistant pressure-sensitive adhesive tape 2 for the production of a semiconductor device at at least one point in a temperature range of from 0 to 180°C to a silicon wafer having the heat-resistant pressure-sensitive adhesive tape 2 adhered thereto is preferably 50 mN/20 mm or more, preferably 100 mN/20 mm or more, and further preferably 200 mN/20 mm or more. When the 180° peel adhesive force is less than 50 mN/20 mm, adhesiveness to the chip may become insufficient, and deviation of chip position may occur by peeling during handling and pressure during resin encapsulation.

After the encapsulation, there are cases where the heat-resistant pressure-sensitive adhesive tape 2 for the production of a semiconductor device strongly adheres to a chip face due to curing of an encapsulation resin and heat, resulting in breakage of a package in peeling the tape. Particularly, since the resin is cured on the pressure-sensitive adhesive layer 12, adhesiveness to the resin tends to be increased. For this reason, when the 180° peel adhesive force of the heat-resistant pressure-sensitive adhesive tape 2 for the production of a semiconductor device at at least one point in a temperature range of from 0 to 180°C to an encapsulation resin cured on the heat-resistant pressure-sensitive adhesive tape 2 is 20 N/20 mm or less, more preferably 15 N/20 mm or less, and further preferably 10 N/20 mm or less, the heat-resistant pressure-sensitive adhesive tape 2 for the production of a semiconductor device can be peeled without breakage of the package. Where the 180° peel adhesive force is more than 20 N/20 mm, the cured encapsulation resin may not withstand peel strength of the heat-resistant pressure-sensitive adhesive tape 2 for the production of a semiconductor device, and breakage may occur. Furthermore, when peeling the heat-resistant pressure-sensitive adhesive tape 2 for the production of a semiconductor device, the tape is preferably peeled at ordinary temperatures from the standpoint of workability. However, in the case that adhesiveness at ordinary temperature is large, an ordinary pressure-sensitive adhesive has a tendency that adhesiveness becomes small and peel strength becomes small in a high-temperature atmosphere. Therefore, the package can be prevented from being broken by peeling the tape in a heated atmosphere.

In the case that the package is contaminated with a gas generated from the heat-resistant pressure-sensitive adhesive tape 2 for the production of a semiconductor device in the step of heat curing the encapsulation resin, reliability of package may be deteriorated (such as poor plating when rewiring). For this reason, when the weight loss at 180°C of the pressure-sensitive adhesive layer 12 (pressure-sensitive adhesive) is 3.0% by weight or less, and preferably 2.0% by weight or less, the pressure-sensitive adhesive layer can be used in this use purpose without deterioration of reliability of the package.

The pressure-sensitive adhesive layer 12 may further include various additives generally used in the art of this field, such as a plasticizer, a pigment, a dye, an antioxidant, an antistatic agent, and a filler added to improve properties (for example, elastic modulus) of the pressure-sensitive adhesive layer 12. The content of the additives added is not particularly limited so long as the amount does not impair appropriate adhesiveness.

The heat-resistant pressure-sensitive adhesive tape 2 for the production of a semiconductor device includes a base material layer and having thereon the pressure-sensitive adhesive layer 12 having a thickness of generally from 1 to 50 µm thus produced, and is used in a form of a sheet, a tape or the like.

### Pressure-sensitive adhesive layer for substrate fixation

A pressure-sensitive adhesive used in the pressure-sensitive adhesive layer 13 for substrate fixation may be the same as that used in the pressure-sensitive adhesive layer 12.
In peeling the heat-resistant pressure-sensitive adhesive tape 2 for the production of a semiconductor device from the substrate, a step of peeling the tape from the substrate can be conducted by heating by adding a foaming agent which foams by heating to the pressure-sensitive adhesive layer 13 for substrate fixation. Furthermore, in place of heating means, when a component which cross-links by ultraviolet rays has been previously added to the pressure-sensitive adhesive layer 13 for substrate fixation, the adhesive force of the pressure-sensitive adhesive layer adhesive layer 13 for substrate fixation can be decreased by curing the pressure-sensitive adhesive layer adhesive layer 13 for substrate fixation.
The adhesive force of the pressure-sensitive adhesive layer 13 for substrate fixation to the substrate or the base material layer is decreased by conducting the above-mentioned treatment, and the heat-resistant pressure-sensitive adhesive tape 2 for the production of a semiconductor device and the base material layer are then peeled from the substrate and the pressure-sensitive adhesive layer 13 for substrate fixation, thereby separating the chip encapsulated with a resin from the substrate.

### Smooth release sheet

The smooth release sheet 10 is a sheet including a base material film and a release agent layer formed on one side thereof, and is a sheet peeled to expose each face of the pressure-sensitive adhesive layer before using the heat-resistant pressure-sensitive adhesive tape for the production of a semiconductor device of the present invention.
The release agent layer can be obtained by appropriately selecting from the conventional release agent layers such as a long chain alkyl type, a fluorine rein type and a silicone resin type, according to the pressure-sensitive adhesive to be contacted therewith.

As the base material film, conventional films may be used and can be selected, for example, from plastic films such as polyether ether ketone, polyether imide, polyarylate, polyethylene naphthalate, polyethylene film, polypropylene film, polybutene film, polybutadiene film, polmethyl pentene film, polyvinyl chloride film, polyvinyl chloride copolymer film, polyethylene terephthalate film, polybutylene terephthalate film, polyurethane film, ethylene-vinyl acetate copolymer film, ionomer resin film, ethylene-(meth)acrylic acid copolymer film, ethylene-(meth)acrylic acid ester copolymer film, polystyrene film and polycarbonate film.

The release agent layer that can be used is a layer containing the release agent selected from the conventional release agents such as fluorinated silicone resin-based release agent, fluorine resin-based release agent, silicone resin-based release agent, polyvinyl alcohol resin, polypropylene resin, and long chain alkyl compound, according to the resin of the pressure-sensitive adhesive layer.

### Production method of heat-resistant pressure-sensitive adhesive tape for production of semiconductor device

The heat-resistant pressure-sensitive adhesive tape 2 for the production of a semiconductor device of the present invention can be produced by general production methods. For example, a composition for constituting a pressure-sensitive adhesive layer such as a silicone pressure-sensitive adhesive layer is dissolved in a given solvent to prepare a coating liquid, the coating liquid is applied to a base material layer so as to obtain a layer structure of the objective heat-resistant pressure-sensitive adhesive tape for the production of a semiconductor device, and the resulting coating layer is then heated and dried under given conditions.
Further, a single film may be prepared by, for example, casting a pressure-sensitive adhesive such as a silicone pressure-sensitive adhesive on a releasable film or the like, and the film may be laminated on a base material. Application of the coating liquid and lamination by the single film may be combined. The solvent used is not particularly limited. Considering the necessity of good solubility of materials for constituting the pressure-sensitive adhesive layer, a ketone-based solvent such as methyl ethyl ketone is preferably used. There may also be used a method of forming a pressure-sensitive adhesive tape where the constitution materials of the pressure-sensitive adhesive layer are made into an aqueous dispersion solution, the solution is applied to a base material layer, the resulting coating layer is heated and dried, and those procedures are repeated, thereby laminating pressure-sensitive adhesive layers.

### Method of using heat-resistant pressure-sensitive adhesive tape for production of semiconductor device

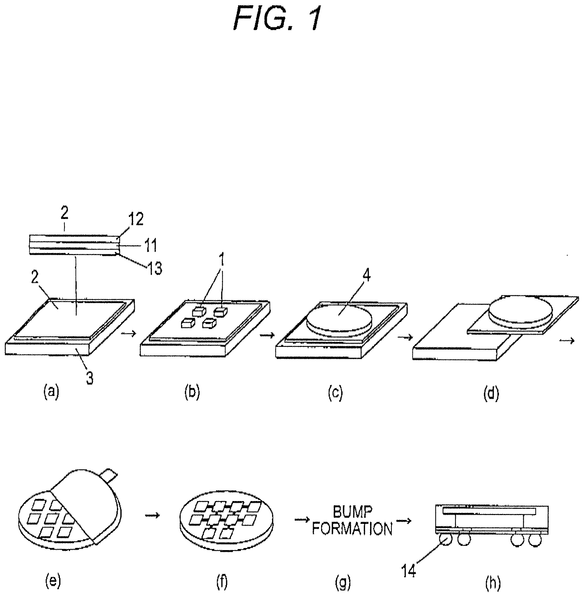

The heat-resistant pressure-sensitive adhesive tape 2 for the production of a semiconductor device is used in steps shown in Fig. 1 and Figs. 2A to 2F, and the like.

As an example, a summary of a process for producing a substrateless BGA is described below.
Fig. 1 is a view showing a method for producing a semiconductor device in which a substrateless semiconductor chip is encapsulated with a resin, the method employing the heat-resistant pressure-sensitive adhesive tape 2 for the production of a semiconductor device of the present invention.
In step (a), the heat-resistant pressure-sensitive adhesive tape 2 for the production of a semiconductor device of the present invention is adhered and fixed to the substrate 3. In step (b), semiconductor chips are adhered and fixed to the tape with an optional interval. In the subsequent step (c), semiconductor chips fixed are encapsulated with an encapsulation resin 4 so as to embed the chips.
In step (d), the plural chips thus encapsulated are peeled together with the encapsulation resin and the heat-resistant pressure-sensitive adhesive tape 2 for the production of a semiconductor device from the substrate by heat peeling. In step (e), the heat-resistant pressure-sensitive adhesive tape 2 for the production of a semiconductor device of the present invention is peeled from the resin-encapsulated semiconductor chips.
In step (f), various pattern printings are applied to an area between the semiconductor chips and the surfaces of the semiconductor chips to form a lead for wiring and the like. In the subsequent step (g), the lead for wiring forms a bump or the like which is a spherical connection electrode on the surface of the chip.
Finally, in step (h), an encapsulation resin part between the semiconductor chips is cut by dicing or the like, thereby each semiconductor device equipped with individual semiconductor chip(s) can be obtained.

The method is specifically described below with reference to Figs. 2A to 2F,

### Adhering step of semiconductor chip

The heat-resistant pressure-sensitive adhesive tape 2 for the production of a semiconductor device is fixed to a substrate by adhesion or the like, and the pressure-sensitive adhesive layer side is exposed on the upper face.
Given semiconductor chips to be encapsulated with a resin are placed on and adhered to the pressure-sensitive adhesive layer so as to obtain a given configuration, thereby fixing the chips to the pressure-sensitive adhesive layer of the heat-resistant pressure-sensitive adhesive tape 2 for the production of a semiconductor device. In this case, structure, shape, size and the like of the semiconductor chip are not particularly limited.

### Encapsulation step

A resin used in an encapsulation step in which the heat-resistant pressure-sensitive adhesive tape 2 for the production of a semiconductor device of the present invention is used may be a conventional encapsulation resin such as epoxy resin. Melting temperature and curing temperature of a powdery resin, and curing temperature of a liquid resin are selected considering heat resistance of the heat-resistant pressure-sensitive adhesive tape 2 for the production of a semiconductor device. The heat-resistant pressure-sensitive adhesive tape 2 for the production of a semiconductor device of the present invention has heat resistance at the melting temperature and curing temperature of ordinary encapsulation resins.
The encapsulation step is conducted in a mold using the above resin for the purpose of protecting a chip, and is conducted at a temperature of, for example, from 170 to 180°C.
After peeling the heat-resistant pressure-sensitive adhesive tape 2 for the production of a semiconductor device, post-mold curing is conducted.

### Peeling step

After the chip fixed to the heat-resistant pressure-sensitive adhesive tape 2 for the production of a semiconductor device on the substrate is encapsulated with a resin, heating is conducted under the conditions at a temperature of from 200 to 250°C for a period of from 1 to 90 seconds (hot plate or the like) or for a period of from 1 to 15 minutes (hot air dryer) to release fixation between the heat-resistant pressure-sensitive adhesive tape 2 for the production of a semiconductor device and the substrate through a pressure-sensitive adhesive or the like, and the heat-resistant pressure-sensitive adhesive tape 2 for the production of a semiconductor device and the substrate are separated to each other.
Thereafter, the heat-resistant pressure-sensitive adhesive tape 2 for the production of a semiconductor device is peeled from the layer including chips encapsulated with a resin.
Alternatively, there may also be used a method where the heat-resistant pressure-sensitive adhesive tape 2 for the production of a semiconductor device and the substrate are not separated to each other and maintain an integrated form, and plural chips encapsulated with an encapsulation resin are separated from the pressure-sensitive adhesive layer of the heat-resistant pressure-sensitive adhesive tape 2 for the production of a semiconductor device.

### Electrode formation step

At a side of the layer including chips encapsulated with a resin, on which the heat-resistant pressure-sensitive adhesive tape 2 for the production of a semiconductor device was laminated and a part of the surfaces of the chips is exposed, an electrode is formed on an given area of each chip by a method such as screen printing. Electrode material used may be a conventional material.

### Dicing step

The layer including chips encapsulated with a resin is fixed to a dicing sheet preferably having a dicing ring, and is cut into each package using a dicing blade used in an ordinary dicing step. In this case, when each chip is not located at a given position, formation of an electrode becomes inaccurate and the position of the chip in each package becomes inaccurate. In the worst case, there is a possibility that the dicing blade contacts the chip when conducting dicing,

When the heat-resistant pressure-sensitive adhesive tape 2 for the production of a semiconductor device of the present invention is used, the position of the chip can be prevented from deviating in the encapsulation step with a resin. Therefore, the dicing step can smoothly be carried out without such a trouble, and as a result, a package in which a chip is accurately located in the encapsulation resin can be obtained.
The present invention is described in more detail by reference to Examples, but it should be noted that the invention is not construed as being limited to the Examples.

### Examples

### EXAMPLE 1

A 25 µm thick polyimide film (KAPTON 100H (trade name), manufactured by Du pont-Toray Co., Ltd., coefficient of linear expansion: 2.7×10⁻⁵/°C, Tg: 402°C) was used as a base material layer. Silicone pressure-sensitive adhesive "SD-4586" manufactured by Dow Coming Toray Silicone Co., Ltd. (100 parts) and a platinum catalyst (3 parts) were added to toluene and uniformly dispersed in toluene. The resulting dispersion was applied to one side of the base material layer, followed by drying. Thus, a heat-resistant pressure-sensitive adhesive layer having about 6 µm thick pressure-sensitive adhesive layer was prepared. Storage modulus at 180°C of the pressure-sensitive adhesive was 4.0×10⁵ Pa. Adhesive force at 23°C of the tape at peel angle to a silicon wafer of 180° was 250 mN/20 mm width. Furthermore, the adhesive force of the pressure-sensitive adhesive tape at peel angle to an encapsulation resin of 180° after resin encapsulation was 3.1 N/20 mm at 23°C.

Weight loss of the pressure-sensitive adhesive after heating at 180°C for 3 hours was 0.1 %, and degree of heat shrinkage of the base material layer after heating at 180°C for 3 hours was 0.35%.
An Si wafer chip having a size of 5 mm × 5 mm was placed on the heat-resistant pressure-sensitive adhesive tape, and a powdery epoxy resin encapsulation resin (GE-7470LA, manufactured by Nitto Denko Corporation) was sprayed thereon, and molded at a temperature of 175°C under a pressure of 3.0 kg/cm² for 2 minutes. The tape was heated at 150°C for 60 minutes to accelerate curing of the resin (post-mold curing). Thus, a package was prepared.

After preparation of the package, deviation distance of the chip from the initial position was measured with a digital microscope. The standoff was measured by cutting the package and measuring the cross-section with a digital microscope. Breakage of the package after peeling the pressure-sensitive adhesive tape was visually confirmed.

### EXAMPLE 2

A pressure-sensitive adhesive tape was obtained in the same manner as in Example 1, except for using a 25 µm thick polyimide film (trade name: APICAL 25NPI, manufactured by Kaneka Corporation, coefficient of linear expansion: 1.7×10^{- 5}/K, Tg: 421°C) as a base material layer. Adhesive force at 23°C of the tape at peel angle to a silicon wafer of 180° was 260 mN/20 mm width. Furthermore, the adhesive force of the pressure-sensitive adhesive tape at peel angle to an encapsulation resin of 180° after resin encapsulation was 3.3 N/20 mm at 23°C.
Weight loss of the pressure-sensitive adhesive after heating at 180°C for 3 hours was 0.1%, and degree of heat shrinkage of the base material layer after heating at 180°C for 3 hours was 0.11%.

### COMPARATIVE EXAMPLE 1

A pressure-sensitive adhesive tape was obtained in the same manner as in Example 1, except for using a 25 µm thick polyphenyl sulfide film (trade name: TORELINA 3030, manufactured by Toray, coefficient of linear expansion: 3.2×10⁻⁵/K, Tg: 127°C) as a base material layer. Adhesive force at 23°C of the tape at peel angle to a silicon wafer of 180° was 260 mN/20 mm width. Furthermore, the adhesive force of the pressure-sensitive adhesive tape at peel angle to an encapsulation resin of 180° after resin encapsulation was 3.0 N/20 mm at 23°C.
Weight loss of the pressure-sensitive adhesive after heating at 180°C for 3 hours was 0.1%, and degree of heat shrinkage of the base material layer after further heating at 180°C for 3 hours was 1.9%.

### COMPARATIVE EXAMPLE 2

A heat-resistant pressure-sensitive adhesive tape was obtained in the same manner as in Example 1, except that a mixture of a pressure-sensitive adhesive obtained by copolymerizing 50 parts of butyl acrylate, 50 parts of ethyl acrylate and 5 parts of acrylic acid, and 3 parts of an isocyanate crosslinking agent was used as the pressure-sensitive adhesive. Storage modulus at 180°C of the pressure-sensitive adhesive was 0.2×10⁵ Pa. Adhesive force at 23°C of the tape at peel angle to a silicon wafer of 180° was 3,000 mN/20 mm width. Furthermore, the adhesive force of the pressure-sensitive adhesive tape at peel angle to an encapsulation resin of 180° after resin encapsulation was 26 N/20 mm at 23°C.
Weight loss of the pressure-sensitive adhesive after heating at 180°C for 3 hours was 0.5%, degree of heat shrinkage of the base material layer after heating at 180°C for 3 hours was 0.35%, 5% weight loss temperature of the pressure-sensitive adhesive was 270°C, and degree of heat shrinkage of the base material layer after heating at 180°C for 3 hours was 0.35%.
The results obtained above are shown in the Table 1 below.

**Table 1**

| Results | | | | | |
|---|---|---|---|---|---|
| | Unit | Example 1 | Example 2 | Comparative Example 1 | Comparative Example 2 |
| Glass transition temperature (Base material layer) | °C | 402 | 421 | 127 | 402 |
| Coefficient of liner expansion | ×10⁻⁵/°C | 2.7 | 1.7 | 3.2 | 2.7 |
| Storage modulus of pressure-sensitive adhesive (180°C) | × 10⁵ Pa | 4.0 | 4.0 | 4.0 | 0.2 |
| Adhesive force (23°C, silicon wafer) | mN/20 mm | 250 | 260 | 260 | 3,000 |
| Adhesive force (23°C, after curing encapsulation resin) | N/20 mm | 3.1 | 3.3 | 3.0 | 26 |
| Weight loss (after heating at 180°C for 3 hours) | % | 0.1 | 0.1 | 0.1 | 0.5 |
| Degree of heat shrinkage (after heating at 180°C for 3 hours) | % | 0.35 | 0.11 | 1.9 | 0.35 |
| Deviation distance of chip (after heating at 180°C for 3 hours) | mm | 0.2 | 0.1 | 1.0 | 0.2 |
| Difference in level between chip face and resin face (stand-off) | µm | 1 µm or less | 1 µm or less | 1 µm or less | 2.5 µm |
| Breakage of package when peeling tape | | None | None | None | Occurred |

In Examples 1 and 2, a chip was surely held in preparing a substrateless semiconductor package which did not use a lead frame, deviation of a chip from the designated position was small, standoff due to embedding in a pressure-sensitive adhesive was small, and after the use, light peeling was possible without breakage of the package.
In Comparative Example 1, the glass transition temperature of the base material layer was low as 127°C, and degree of heat shrinkage thereof was large. As a result, deviation distance of the chip after heating at 180°C for 3 hours was large, and a desired stable semiconductor device was not obtained in the subsequent electrode formation and dicing step.
In Comparative Example 2, storage modulus of the pressure-sensitive adhesive layer of the heat-resistant pressure-sensitive adhesive tape after curing the encapsulation resin was low. Therefore, the chip was embedded in the pressure-sensitive adhesive layer in the resin encapsulation step, thereby large standoff of 2.5 µm occurred, and due to high adhesive force of the pressure-sensitive adhesive layer, the package was broken when peeling.

As is clear from the above results, according to the present invention, there can be obtained a heat-resistant pressure-sensitive adhesive tape for the production of a semiconductor device which is capable of surely holding the chip during the resin capsulation step, and in which deviation of the chip from the designated position is small, standoff due to embedding of the chip in the pressure-sensitive adhesive layer is small, and light-peeling is possible after the use.

While the invention has been described in detail and with reference to specific embodiments thereof, it will be apparent to one skilled in the art that various changes and modifications can be made therein without departing from the scope thereof.

This application is based on Japanese patent application No. 2010-206159 filed September 14,2010, the entire contents thereof being hereby incorporated by reference.

## Claims

1. A heat-resistant pressure-sensitive adhesive tape for the production of a semiconductor device, which is to be used by being adhered to a substrateless semiconductor chip which does not use a metal lead frame in encapsulating the chip with a resin,
the tape comprising a base material layer having a glass transition temperature exceeding 180°C, and a pressure-sensitive adhesive layer having an elastic modulus at 180°C of 1.0×10⁵ Pa or more, which is formed on one side or both sides of the base material layer.

2. The heat-resistant pressure-sensitive adhesive tape for the production of a semiconductor device according to claim 1, wherein the base material layer has a coefficient of linear expansion in a temperature range of from 0 to 180°C of 3.0×10⁻⁵/°C or less.

3. The heat-resistant pressure-sensitive adhesive tape for the production of a semiconductor device according to claim 1 or 2, which has a 180° peel adhesive force at at least one point in a temperature range of from 0 to 180°C to a silicon wafer of 50 mN/20 mm or more.

4. The heat-resistant pressure-sensitive adhesive tape for the production of a semiconductor device according to any one of claims 1 to 3, which has a 180° peel adhesive force at at least one point in a temperature range of from 0 to 180°C to an encapsulation resin cured on the pressure-sensitive adhesive layer of 20 N/20 mm or less.

5. The heat-resistant pressure-sensitive adhesive tape for the production of a semiconductor device according to any one of claims 1 to 4, wherein the pressure-sensitive adhesive layer has a weight loss at 180°C of 3.0% by weight or less.

6. A method for producing a semiconductor device in which a substrateless semiconductor chip which does not use a metal lead frame is encapsulated with a resin, the method comprising using the heat-resistant pressure-sensitive adhesive tape for the production of a semiconductor device according to any one of claims 1 to 5.
